# EUROPEAN PATENT APPLICATION

(11) **EP 1 918 417 A1**
(43) Date of publication of application: **07.05.2008**
(21) Application number: 06768005.8
(22) Date of filing: 07.07.2006
(51) Int. Cl.: C23C 16/42, C23C 16/455, C23C 16/46, H01L 21/285

(54) **METHOD OF FORMING FILM AND APPARATUS FOR FILM FORMATION**

(30) Priority: 07.07.2005 JP 2005199281; 05.07.2006 JP 2006185655
(71) Applicant: Tokyo Electron Limited (TEL), Tokyo 107-8481 (JP)
(72) Inventor: NAKAMURA, Kazuhito, 4550042 (JP); YAMASAKI, Hideaki, Tokyo Electron AT Limited, Nirasaki-shi, Yamanashi, 4070192 (JP); KAWANO, Yumiko, Tokyo Electron Limited, Yamanashi, 4070192 (JP)
(74) Representative: HOFFMANN EITLE
(86) International application number: PCT/JP2006/313595
(87) International publication number: WO 2007/007680

(57) **Abstract**

The present invention is a method of film deposition that comprises a first gas-supplying step of supplying a high-melting-point organometallic material gas to a processing vessel that can be evacuated, and a second gas-supplying step of supplying, to the processing vessel, a gas consisting of one, or two or more gases selected from a nitrogen-containing gas, a silicon-containing gas, and a carbon-containing gas, wherein a thin metallic compound film composed of one, or two or more compounds selected from a high-melting-point metallic nitride, a high-melting-point metallic silicate, and a high-melting-point metallic carbide is deposited on the surface of an object to be processed, placed in the processing vessel. The first and second gas-supplying steps are alternately carried out, and in these steps, the object to be processed is held at a temperature equal to or higher than the decomposition-starting temperature of the high-melting-point organometallic material.

## Description

### BACKGROUND OF THE INVENTION

### Field of the Invention

The present invention relates to a method of film deposition for forming a thin film on an object to be processed, such as a semiconductor wafer, and to a film deposition system.

### Background Art

Generally, in the production of semiconductor integrated circuits, objects to be processed, such as semiconductor wafers, are repeatedly subjected, sheet by sheet, to various processing steps, such as film deposition, etching, heat treatment, modification, and recrystallization, thereby obtaining desired integrated circuits. Moreover, the recent demand for thinner integrated circuits having higher levels of integration has made the line width, film thickness, etc. of integrated circuits much smaller than ever.

Nitrided films of high-melting-point organometallic materials tend to be often used as materials that show relatively low resistivity even when they are made thinner than ever and patterned to have extremely small line widths, that are excellent in adhesion with dissimilar materials, and that can be deposited at relatively low temperatures. Examples of nitrided films of high-melting-point organometallic materials include TaN (tantalum nitride film). There is also such a case where silicon, carbon, or both of these elements are incorporated into tantalum nitride film, as needed, to give TaSiN, TaCN, or TaSiCN film, respectively.

For example, tantalum nitride film is often used, in a transistor, as a gate electrode, as a barrier layer to be interposed between a metal gate electrode and a polysilicon layer formed on it, as a barrier layer to be used for making contact via through holes, via holes, etc., or as a barrier layer for aluminum or copper wiring, and, in a capacitor, as an upper or lower electrode.

A nitrided film of a high-melting-point organometallic material, such as tantalum nitride film, is usually formed by the CVD (Chemical Vapor Deposition) method, or by the ALD (Atomic Layer Deposition) method in which extremely thin films are successively layered, one over the other, by alternately and repeatedly feeding a high-melting-point organometallic material gas and a nitride gas (Published Japanese Translation No. 2005-512337, and Japanese Laid-Open Patent Publications No. 2002-50588 and No. 2004-277772).

In the above-described methods of film deposition, a high-melting-point organometallic material gas is usually used as a material gas.

In the CVD method, a high-melting-point organometallic material gas and NH₃ and SiH₄ (monosilane) are fed at the same time to cause gas phase reaction at such a high temperature that the high-melting-point organometallic material thermally decomposes completely. As a result, a thin film is deposited.

The CVD method had no problem in the past when design rules were not so strict. However, since they have become very strict recently and mask patterns prescribed by them have become smaller in line width and higher in aspect ratio, the CVD method has become disadvantageous in that, although a thin film is deposited on the trenched upper surface of a wafer at a relatively high rate, the step coverage of the thin film deposited is low.

On the other hand, in the ALD method in which a high-melting-point organometallic material gas and a nitride gas are alternately fed, a wafer surface, held at a temperature below the thermal decomposition temperature of the high-melting-point organometallic material, adsorbs the material gas, and the nitride gas that is fed following the material gas nitrides the adsorbed material gas to form an extremely thin film. Since this process of thin film deposition is repeatedly carried out, the step coverage of the thin film deposited is relatively high.

In this method, however, the film deposition rate at which the material gas and the nitride gas form a film is approximately 1 to 2 angstroms per cycle. The ALD method is thus disadvantageous in that the film deposition rate is extremely low and that the throughput is poor.

### SUMMARY OF THE INVENTION

In view of the aforementioned problems in the prior art and in order to solve them effectively, we accomplished the present invention. Accordingly, an object of the present invention is to provide a method of film deposition and a film decomposition system that can ensure high step coverage and high film deposition rate.

The present invention is a method of film deposition that comprises: a first gas-supplying step of supplying a high-melting-point organometallic material gas to a processing vessel that can be evacuated; and a second gas-supplying step of supplying, to the processing vessel, a gas consisting of one, or two or more gases selected from a nitrogen-containing gas, a silicon-containing gas and a carbon-containing gas; wherein a thin metallic compound film composed of one, or two or more compounds selected from a high-melting-point metallic nitride, a high-melting-point metallic silicate, and a high-melting-point metallic carbide is deposited on the surface of an object to be processed, placed in the processing vessel, characterized in that the first and second gas-supplying steps are alternately carried out, and that, in the first and second gas-supplying steps, a temperature of the object to be processed is kept equal to or higher than a decomposition-starting temperature of the high-melting-point organometallic material.

According to the present invention, the step coverage can be kept high by alternately carrying out the first and second gas-supplying steps, and the film deposition rate can also be kept high by keeping the temperature of the object to be processed equal to or higher than the decomposition-starting temperature of the high-melting-point organometallic material. Namely, the present invention can have the advantages of both the CVD and ALD methods.

Preferably, a purging step of purging the gas remaining in the processing vessel is carried out between the first and second gas-supplying steps.

More preferably, the purging step of purging the gas remaining in the processing vessel is carried out after the first gas-supplying step and before the second gas-supplying step so that at least the high-melting-point organometallic material gas remains in the atmosphere in the processing vessel.

Further, for example, the second gas-supplying step comprises a step of supplying a nitrogen-containing gas, and a metallic-nitride-containing compound film is deposited.

Furthermore, for example, the second gas-supplying step comprises a step of supplying a silicon-containing gas, and a silicon-containing metallic compound film is deposited.

In this case, the silicon-containing gas is selected from the group consisting of monosilane [SiH₄], disilane [Si₂H₆], methylsilane [CH₃SiH₃], dimethylsilane [(CH₃)₂SiH₂], hexamethyldisilazane (HMDS), disilylamine (DSA), trisilylamine (TSA), bistertiarybutylaminosilane (BTBAS), trimethylsilane, tetramethylsilane, bisdimethylaminosilane, tetradimethyl-aminosilane, triethylsilane, and tetraethylsilane.

Furthermore, for example, the second gas-supplying step comprises a step of supplying a nitrogen-containing gas and a step of supplying a silicon-containing gas, the step of supplying a silicon-containing gas being carried out in the step of supplying a nitrogen-containing gas, and a metallic-nitride-containing compound film and a silicon-containing metallic compound film are deposited.

Furthermore, for example, the second gas-supplying step comprises a step of supplying a carbon-containing gas, and a metallic-carbide-containing compound film is deposited.

Furthermore, for example, the second gas-supplying step comprises a step of supplying a nitrogen-containing gas and a step of supplying a carbon-containing gas, the step of supplying a carbon-containing gas being carried out in the step of supplying a nitrogen-containing gas, and a metallic-nitride-containing compound film and a metallic-carbide-containing compound film are deposited.

For example, the high-melting-point organometallic material contains a metal selected from Ta (tantalum), Ti (titanium), W (tungsten), Hf (hafnium), and Zr (zirconium).

Specifically, for example, the high-melting-point organometallic material is a high-melting-point organometallic material containing tantalum and is a compound selected from the group consisting of t-butyliminotris(diethylamino)tantalum (TBTDET):[(NEt₂)₃TaN-Bu^{t}],
pentakis(ethylmethylamino)tantalum (PEMAT):[Ta(NMeEt)₅],
pentakis-(dimethylamino)tantalum (PDMAT):[Ta(NMe₂)₅],
pentakis(diethylamino)-tantalum (PDEAT):[Ta(NEt₂)₆],
t-butyliminotris(ethylmethylamino)tantalum
(TBTMET):[(NEt₂Me)₃TaN-Bu^{t}],
t-amylimidotris(dimethylamino)tantalum
(TBTDMT):[(NMe₂)₃TaN-Bu^{t}], and
t-amylimidotris(dimethylamino)tantalum
(Taimata):[(NMe₂)₃TaNC(CH₃)₂C₂H₅] (Ta(Nt-Am)(NMe₂)₃).

Alternatively, the high-melting-point organometallic material is a high-melting-point organometallic material containing titanium, for example, and is a compound selected from the group consisting of tetrakisdiethylaminotitanium Ti[N(C₂H₅)₂]₄, tetrakisdimethylaminotitanium Ti[N(CH₃)₂]₄, and tetrakisethylmethylaminotitanium Ti[N(CH₃)(C₂H₅)]₄.

Alternatively, the high-melting-point organometallic material is a high-melting-point organometallic material containing tungsten, for example, and is a compound selected from the group consisting of hexacarbonyltungsten W(CO)₆, and bistertiarybutylimidobisdimethyl-amidotungsten (t-Bu^{t}N)₂(Me₂N)₂W.

Alternatively, the high-melting-point organometallic material is a high-melting-point organometallic material containing hafnium, for example, and is a compound selected from the group consisting of tetrakisdimethylaminohafnium Hf[N(CH₃)₂]₄, and dimethylbis(cyclopenta-dienyl)hafnium Hf(CH₃)₂ (C₅H₅)₂.

For example, the nitrogen-containing gas is a compound selected from the group consisting of ammonia [NH₃], hydrazine [NH₂NH₂], methylhydrazine [(CH₃)(H)NNH₂], dimethylhydrazine [(CH₃)₂NNH₂], t-butylhydrazine [(CH₃)₃C(H)NNH₂], phenylhydrazine [C₆H₅N₂H₃], 2,2'-azo-isobutane [(CH₃)₆C₂N₂], ethylazide [C₂H₅N₃], pyridine [C₅H₅N], and pyrimidine [C₄H₄N₂].

For example, the carbon-containing gas is a compound selected from the group consisting of acetylene, ethylene, methane, ethane, propane, and butane.

Further, the present invention is a film deposition system comprising: a processing vessel that can be evacuated; a supporting unit for supporting, in the processing vessel, an object to be processed; a heating unit for heating the object to be processed supported by the supporting unit; a high-melting-point-organometallic-material-gas-supplying unit for supplying a high-melting-point organometallic material gas; a reactant-gas-supplying system for supplying a gas, or two or more gases, selected from a nitrogen-containing gas, a silicon-containing gas, and a carbon-containing gas; a gas-feeding unit connected to the high-melting-point-organometallic-material-gas-supplying unit and the reactant-gas-supplying system, for feeding to the processing vessel the gas, or the two or more gases, selected from a nitrogen-containing gas, a silicon-containing gas and a carbon-containing gas, and the high-melting-point organometallic material gas; and a controller for controlling the gas-feeding unit and the heating unit, in order to deposit a thin metallic compound film on the object to be processed, in such a manner that a step of supplying the high-melting-point organometallic material gas and a step of supplying the gas, or the two or more gases, selected from a nitrogen-containing gas, a silicon-containing gas, and a carbon-containing gas are alternately carried out and that a temperature of the object to be processed is kept equal to or higher than a decomposition-starting temperature of the high-melting-point organometallic material.

Preferably, the film deposition system further comprises a gas-exhausting unit for exhausting the gas in the processing vessel, and the controller is adapted to control the gas-feeding unit and the gas-exhausting unit in such a manner that a purging step of purging the gas remaining in the processing vessel is carried out after the step of supplying the high-melting-point organometallic material gas and before the step of supplying the gas, or the two or more gases, selected from a nitrogen-containing gas, a silicon-containing gas and a carbon-containing gas, so that at least the high-melting-point organometallic material gas remains in the atmosphere in the processing vessel.

Furthermore, the present invention is a storage medium that stores a computer program with which a computer performs a method of controlling a film deposition system including: a processing vessel that can be evacuated; a supporting unit for supporting, in the processing vessel, an object to be processed; a heating unit for heating the object to be processed, supported by the supporting unit; a high-melting-point-organometallic-material-gas-supplying unit for supplying a high-melting-point organometallic material gas; a reactant-gas-supplying system for supplying a gas, or two or more gases, selected from a nitrogen-containing gas, a silicon-containing gas, and a carbon-containing gas; and a gas-feeding unit connected to the high-melting-point-organometallic-material-gas-supplying unit and the reactant-gas-supplying system, for feeding to the processing vessel the gas, or the two or more gases, selected from a nitrogen-containing gas, a silicon-containing gas and a carbon-containing gas, and the high-melting-point organometallic material gas; the method being for controlling the gas-feeding unit and the heating unit, in order to deposit a thin metallic compound film on the object to be processed, in such a manner that a step of supplying the high-melting-point organometallic material gas and a step of supplying the gas, or the two or more gases, selected from a nitrogen-containing gas, a silicon-containing gas, and a carbon-containing gas are alternately carried out and that a temperature of the object to be processed is kept equal to or higher than a decomposition-starting temperature of the high-melting-point organometallic material.

### BRIEF DESCRIPTION OF THE DRAWINGS

Fig. 1 is a sectional, structural view showing an embodiment of the film deposition system according to the present invention.
Fig. 2 is a diagram showing a gas supply mode in a first embodiment of the method of the present invention.
Fig. 3A is an illustration for explaining a step coverage of a silicon-containing metallic nitride film (TaSiN) deposited on a trenched wafer surface by a conventional method. Figs. 3B and 3C are illustrations for explaining the step coverage of silicon-containing metallic nitride films (TaSiN) deposited on trenched wafer surfaces by the method of the invention.
Fig. 4 shows an electron microscope photograph of a thin film deposited by the conventional, common CVD method (CVD conducted by supplying respective gases at the same time), and its sketch.
Figs. 5A and 5B show electron microscope photographs of thin films deposited by the method of the invention, and their sketches.
Fig. 6 is a graph showing film deposition rates determined by varying the partial pressure of NH₃ gas to the total pressure of SiH₄ gas and NH₃ gas.
Fig. 7 is a graph showing the relationship between SiH₄ gas partial pressure and film deposition rate.
Fig. 8 is a graph showing the relationship between purge gas (Ar) flow rate and film deposition rate.
Fig. 9 is a graph showing the relationship between heater preset temperature and film deposition rate.
Fig. 10 is a diagram showing a gas supply mode in a second embodiment of the method of the present invention.
Fig. 11 is a diagram showing a gas supply mode in a third embodiment of the method of the present invention.
Fig. 12 is a diagram showing a gas supply mode in a fourth embodiment of the method of the present invention.
Fig. 13 is a diagram showing a gas supply mode in a fifth embodiment of the method of the present invention.

### BEST MODE FOR CARRYING OUT THE INVENTION

Embodiments of the film deposition system and the method of film deposition according to the invention will be described hereinafter with reference to the accompanying drawings.

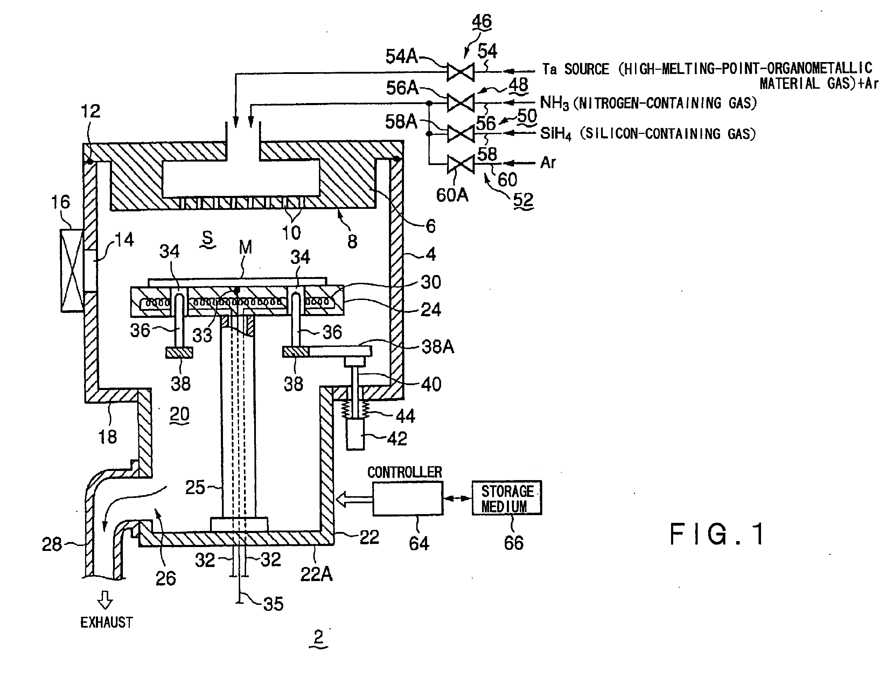

Fig. 1 is a sectional, structural view showing an embodiment of the film deposition system according to the present invention. For example, Ta[NC(CH₃)₂C₂H₅] [N(CH₃)₂]₃:Ta(Nt-Am)(NMe₂)₃ (hereinafter also referred to as "a Ta source") is herein used as the high-melting-point organometallic material. Further, among a nitrogen-containing gas, a silicon-containing gas, and a carbon-containing gas, a nitrogen-containing gas and a silicon-containing gas are used as reactant gases in order to deposit a metallic compound film. Specifically, NH₃ gas and monosilane (SiH₄) are used as a nitrogen-containing gas and a silicon-containing gas, respectively, and silicon-containing tantalum nitride film (TaSiN) is deposited as a metallic compound film.

As shown in the figure, a heat processing system 2 has an aluminum-made processing vessel 4 whose inside is nearly cylindrical. A shower head 6 that is a gas-feeding unit for feeding necessary process gases, such as the Ta source, NH₃ gas, monosilane gas, and Ar gas, is attached to the ceiling of the processing vessel 4. A gas-jetting face 8, i.e., the underside face of the shower head 6, has a large number of gas-jetting holes 10. From the gas-jetting holes 10, the process gases are jetted towards a processing space S. Alternatively, the shower head 6 may have a so-called post-mix structure that allows the Ta source to be fed separately from NH₃ and monosilane gas.

At the joint of this shower head 6 and an upper end opening of the processing vessel 4 is placed a sealing member 12 composed of an O ring, for example. Owing to such a sealing member 12, the processing vessel 4 can be kept airtight.

The processing vessel 4 has, in its sidewall, a gate 14 through which a semiconductor wafer W as an object to be processed is carried in or out of the processing vessel 4. The gate 14 is provided with an on-off gate valve 16 capable of closing the gate 14 to keep the processing vessel 4 airtight.

The processing vessel 4 has an exhaust-gas-trapping space 20 at its bottom 18. Specifically, there is a large opening in the center of the bottom 18 of the processing vessel 4, and from this opening, a cylindrical defining wall 22 with a closed bottom end extends downwardly. The internal space surrounded by the cylindrical defining wall 22 is the exhaust-gas-trapping space 20. At the bottom 22A of the cylindrical wall 22 defining the exhaust-gas-trapping space 20, there stands upright a support 25 in the shape of, for example, a circular cylinder. To the upper end of the support 25 is fixed a table 24 serving as a supporting unit. The wafer M is placed on and held (supported) by this table 24.

The diameter of the opening of the above-described exhaust-gas-trapping space 20 is smaller than that of the table 24. Therefore, a process gas that flows downwardly along the periphery of the table 24 comes under the table 24 and then flows into the space 20. The cylindrical defining wall 22 has, in its lower part, an exhaust port 26 communicating with the exhaust-gas-trapping space 20. The exhaust port 26 communicates also with an evacuation system 28 composed of a vacuum pump, a pressure-regulating valve, etc., which are not shown in the figure. The processing vessel 4 and the exhaust-gas-trapping space 20 can thus be evacuated. By automatically adjusting the degree of the openness of the pressure-regulating valve, the internal pressure of the processing vessel 4 can be kept constant or quickly changed to the desired pressure.

Inside the table 24, there is, as a heating unit, an electrical resistance heater 30 in a predetermined pattern. The exterior of the table 24 is made of a ceramic material, such as sintered AIN. As mentioned previously, a semiconductor wafer M, an object to be processed, can be placed on the upper surface of the table 24. The electrical resistance heater 30 is connected to a feeder line 32 laid inside the support 25, whereby controlled electric power is supplied to the electrical resistance heater 30. On the upper surface side of the table 24 is set a temperature-sensing unit such as a thermocouple 33. A lead wire 35 extending from this thermocouple 33 penetrates the support 25 and is drawn to the outside. A temperature of the wafer M is controlled according to a value (temperature) sensed by the thermocouple 33. Instead of the electrical resistance heater 30, a heating lamp may be used as a heating unit.

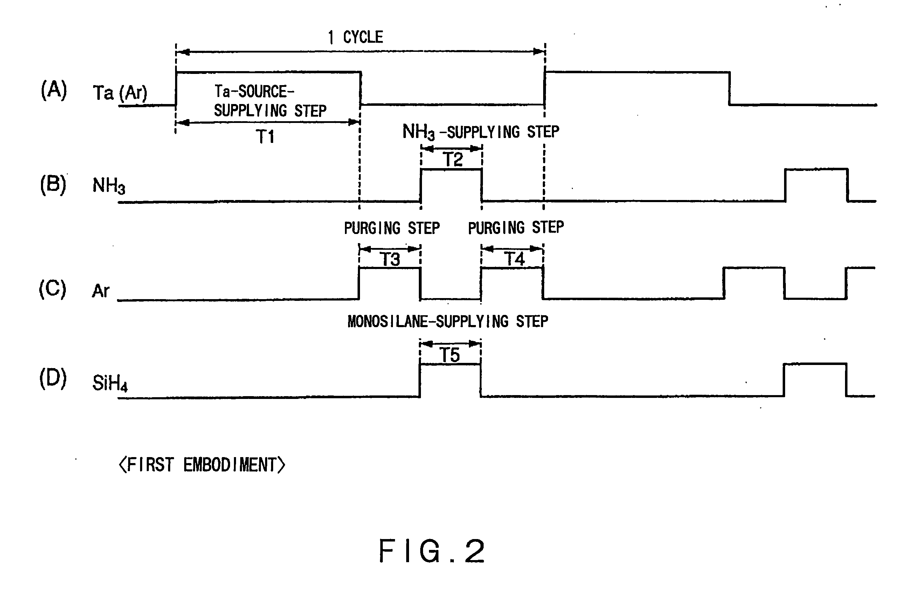

The table 24 has two or more, e.g., three, pin-insertion holes 34 vertically penetrating it (shown in Figs. 1 and 2 are only two of the pin-insertion holes). In each pin-insertion hole 34, a lifting pin 36 is inserted in such a loose fit state that it can move up and down. To the lower end of the lifting pin 36 is fixed a lifting ring 38 made of ceramic, such as alumina, in the shape of an arc like an annular ring partially cut away. Namely, the lower end of each lifting pin 36 is supported by the upper surface of the lifting ring 38. An arm 38A extending from the lifting ring 38 is connected to a rod 40 penetrating the bottom 18 of the vessel. This rod 40 can be elevated by means of an actuator 42. This mechanism allows the lifting pins 36 to be raised above and lowered into the respective pin-insertion holes 34, thereby delivering a wafer M. Further, a stretchable bellows 44 is placed between the rod-penetrating hole in the bottom of the processing vessel 4 and the actuator 42. The bolt 40 can therefore go up and down while retaining the airtightness of the processing vessel 4.

To the shower head 6 are connected gas-supplying systems for supplying necessary process gases. Specifically, a high-melting-point-organometallic-material-gas-supplying system 46 for supplying a high-melting-point organometallic material gas, as well as a nitrogen-containing-gas-supplying system 48 for supplying a nitrogen-containing gas, which is one reactant-gas-supplying system, and a silicon-containing-gas-supplying system 50 for supplying a silicon-containing gas, which is another reactant-gas-supplying system, are connected to the shower head 6. A purge-gas-supplying system 52 is also connected to the shower head 6.

Specifically, the gas-supplying systems 46, 48, 50, 52 have gas lines 54, 56, 58, 60, respectively, and there are on-off valves 54A, 56A, 58A, 60A in the gas lines 54, 56, 58, 60, respectively, in their end sections. The start and stoppage of supply of each gas can thus be freely controlled. Further, flow controllers such as mass flow controllers (not shown in the figure) are in the gas lines 54, 56, 58, 60 on the upstream side. The supply flow rates of the respective gasses are controllable by these controllers. Furthermore, between the on-off valves 54A, 56A, 58A, 60A and the shower head 6, flow paths may be provided so that they by-pass the processing vessel 4 and directly connect the gas supply systems and an exhaust system. By exhausting the gases through the flow paths when not supplying the gases to the shower head 6, their flow rates can be kept stable. This manner works as a way of stopping the supply of the gases.

The high-melting-point organometallic material is bubbled through an inert gas such as Ar gas or vaporized by a vaporizer, and is then supplied as a high-melting-point organometallic material gas.

The Ta source carried by Ar gas is herein used as the high-melting-point organometallic material gas, as mentioned previously. NH₃ gas is used as the nitrogen-containing gas, monosilane (SiH₄) as the silicon-containing gas, and Ar gas as the purge gas. The above-described carrier gas serves also as a dilution gas.

In order to control the whole operation of this film deposition system 2, i.e., the start and stoppage of supply of each gas, and the regulation of wafer temperature, process pressure, etc., a controller 64 composed of a microcomputer and so forth is provided. This controller 64 has a storage medium 66 that stores a program for controlling the operation of the film deposition system as described above, and this storage medium 66 is composed of a floppy disc or a flush memory, for example.

Next, the operation of the film deposition system having the aforementioned structure will be described. As mentioned above, the following operations are controlled in accordance with the program stored in the storage medium 66.

Before carrying a semiconductor wafer M into the processing vessel 4 of the film deposition system 2, the processing vessel 4, connected to a load-lock chamber, for example, which is not shown in the figure, is evacuated. Further, the table 24 on which the wafer M is to be placed is heated to a predetermined temperature beforehand by the electrical resistance heater 30, a heating unit, and the temperature is stably maintained.

Under such conditions, an untreated semiconductor wafer M with a diameter of e.g., 300 mm, held by a carrier arm not shown in the figure, is carried in the processing vessel 4 through the gate 14 with the gate valve 16 opened. The raised lifting pins 36 receive this wafer M and are then lowered, whereby the wafer M is placed on the upper surface of the table 2.

Thereafter, various gases are alternately and repeatedly supplied to the shower head 6, as will be described later. Simultaneously with this, the vacuum pump in the evacuation system 28 is continuously driven to evacuate both the processing vessel 4 and the exhaust-gas-trapping space 20, and the openness of the pressure-regulating valve is adjusted to hold the atmosphere in the processing space S at a predetermined process pressure. Thus, a metallic nitride film is deposited on the surface of the semiconductor wafer M.

Gas supply modes will be specifically described hereinafter.

### <First Embodiment>

The first embodiment of the method of film deposition according to the present invention will be described.

Fig. 2 is a diagram showing a gas supply mode in the first embodiment of the method of the invention. In the following description, explanation will be given by referring to the case where silicon-containing tantalum nitride film (TaSiN) is formed as a metallic nitride film, a metallic compound film.

As shown in Fig. 2, a step of supplying the Ta source (Fig. 2(A)) and a step of supplying NH₃ gas (Fig. 2(B)) are alternately carried out two or more times. In this embodiment, a purging step of purging the gas remaining in the processing vessel 4 is carried out between the Ta source-supplying step and the NH₃ gas-supplying step. In this purging step, Ar gas is fed as a purge gas, as shown in Fig. 2(C), to accelerate exhaust of the gas remaining in the vessel. In this step, it is preferable to purge the vessel to such an extent that the Ta source gas remains in the processing vessel 4. Other inert gas, such as N₂, He, or Ne, may also be used as a purge gas. Further, in the purging step, only evacuation may be continued with the supply of all the gases stopped.

In the course of the NH₃ gas-supplying step, a SiH₄ gas-supplying step is carried out (Fig. 2(D)). By doing so, silicon (Si) is incorporated into tantalum nitride film to be deposited, and TaSiN film is formed. If SiH₄ gas is not supplied, TaN film is deposited. SiH₄ gas is herein supplied simultaneously with and in synchronization with the supply of NH₃ gas.

In the above-described process, the time interval between the starting point of the Ta source-supplying step and that of the next Ta source-supplying step is defined as one cycle.

The following are the process conditions.

Period T1 of the Ta source-supplying step is preferably set within the range of 1 to 60 seconds, e.g., to 30 seconds. Both period T2 of the NH₃ gas-supplying step and period T5 of the monosilane-supplying step are preferably set within the range of 1 to 60 seconds, e.g., to 10 seconds. Periods T3 and T4 of the purging steps before and after the NH₃ gas-supplying step, respectively, are preferably set within the range of 1 to 60 seconds, e.g., to 10 seconds.

The Ta source flow rate in the Ta source-supplying step (period T1) is preferably in the range of 0.1 to 20 sccm; it is controlled by regulating the source bottle temperature and the flow rate of Ar gas, a carrier gas. The source bottle temperature and the Ar carrier gas flow rate are herein set to 46.5°C and 100 sccm, respectively. Ar gas for dilution is further fed at a flow rate of 250 sccm.

The NH₃ flow rate in the NH₃ gas-supplying step (period T2) is preferably in the range of 10 to 1000 sccm and is herein set to 200 sccm. The SiH₄ flow rate in the monosilane-supplying step (period T5) is preferably from 10 to 1000 sccm and is herein set to 200 sccm.

The Ar flow rate in the two purging steps (periods T3 and T4) is preferably in the range of 5 to 2000 sccm and is herein set to 20 sccm.

The pressure at which processing is conducted is preferably from 1.3 to 667 Pa and is herein held constant at 40 Pa.

The wafer M is held at a temperature equal to or higher than a decomposition-starting temperature of the high-melting-point organometallic material serving herein as a Ta source. This is the characteristic feature of the present invention. In general, high-melting-point organometallic materials have thermal decomposition characteristics that are relatively broad in terms of temperature, although they depend also on pressure. For example, the decomposition temperature of the above-described Ta source Ta(Nt-Am)(NMe₂)₃ is said to be about 350°C. It is, however, presumed that the Ta source should actually begin to decompose, though very slightly, when its temperature exceeds 250°C, and decompose significantly at a temperature in the vicinity of 300°C, more significantly at above 300°C, as shown in Table 1 that will be described later, although this depends also on the pressure conditions.

Therefore, the decomposition-starting temperature of the Ta source can be said to be slightly higher than 250°C. The wafer temperature is lower than the temperature of the electrical resistance heater 30 (heater temperature = table temperature) (there is a difference between the wafer temperature and the heater temperature), and the difference between the two temperatures is about 20 to 60°C although it depends also on the process conditions. In this embodiment, when the heater temperature is set to 400°C, the wafer temperature becomes about 350°C. If the heater temperature is made excessively high, a thick film is deposited by CVD when the Ta source is fed. In this case, although the film deposition rate becomes higher, the step coverage drastically lowers. According to the inventors' knowledge, in order to avoid excessive decrease in step coverage, it is necessary that the upper limit of the wafer temperature be set to about "the decomposition-starting temperature + 400°C", more preferably about "the decomposition-starting temperature + 200°C".

Thus, when the wafer temperature is set to a temperature equal to or higher than the decomposition-starting temperature of the Ta source, but not to an excessively high temperature, film deposition on the surface of the wafer M progresses while providing the advantages of both CVD-type and ALD-type deposition. In other words, since the wafer temperature is set to a temperature equal to or higher than the decomposition-starting temperature of the Ta source, but not to an excessively high temperature, film deposition reaction takes time when the Ta source is supplied in the Ta source-supplying step. Namely, even if the Ta source molecules are deposited on the wafer surface, only a very small part of them thermally decompose to form a film in the limited time of the Ta source-supplying step period. And NH₃ gas is fed after the gas remaining in the vessel has been mostly removed in the subsequent purging step. Since Ta(Nt-Am)(NMe₂)₃ and NH₃ begin to react with each other at a temperature of 140°C, as shown in Table 1 that will be described later, the Ta source that has not decomposed in the Ta source-supplying step and that has remained on the wafer surface without being exhausted in the purging step decomposes instantly to form TaN film. It is thus considered that NH₃ drastically lowers the decomposition temperature of the Ta source and acts catalytically.

By performing the above-described film deposition method, the step coverage can be kept high even if the film deposition is conducted at a temperature, herein at a wafer temperature of about 300°C, higher than the temperature at which the conventional ALD method has been performed, e.g., about 250°C when expressed by wafer temperature. Of course, the film deposition rate is high.

Forty cycles of film deposition were practically repeated under the above-described process conditions. As a result, TaSiN film with a thickness of 95 nm was obtained. This is equivalent to a film deposition rate of 2.38 nm per cycle. Thus, there can be attained a deposition rate as high as about 10 times the conventional film deposition rate, which is 1 to 2 angstroms/cycle (0.1 to 0.2 nm/cycle). Since the Ta source used is a high-melting-point organometallic material, it of course contains C (carbon) and TaSiCN film is formed.

TaSiN film was deposited on a wafer surface having trenches with an aspect ratio of about 5.5, and its step coverage was determined. As a result, it was found that the step coverage was improved to 90%. This will be described below in detail.

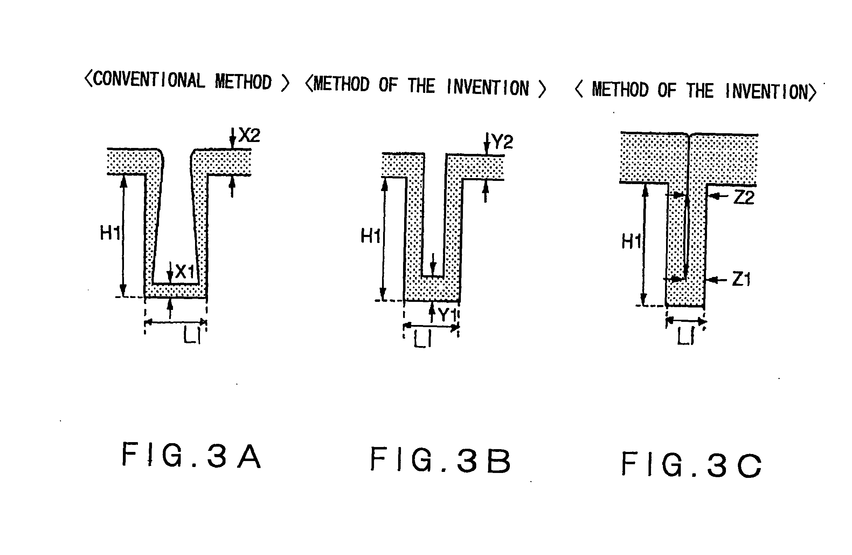

Figs. 3A to 3C are illustrations for explaining the step coverage of silicon-containing metallic nitride films (TaSiN) formed on trenched wafer surfaces. Fig. 3A shows a film deposited by a conventional method (CVD), and Figs. 3B and 3C show films deposited by the method of the invention. The aspect ratios [H1/L1] of the trenches shown in Figs. 3A, 3B, and 3C were 1.8, 2.1, and 5.5, respectively. Although the step coverage of the film shown in Fig. 3A was "X1/X2 ×100 = 20%", the step coverage of the film deposited by the method of the invention, shown in Fig. 3B, was "Y1/Y2 ×100 = 100%" and that of the film deposited by the method of the invention, shown in Fig. 3C, was "Z1/Z2 ×100 = 90%".

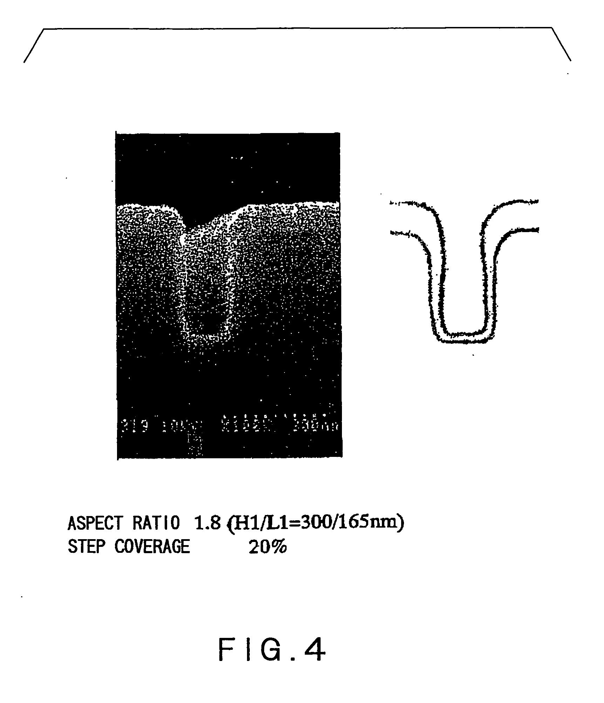

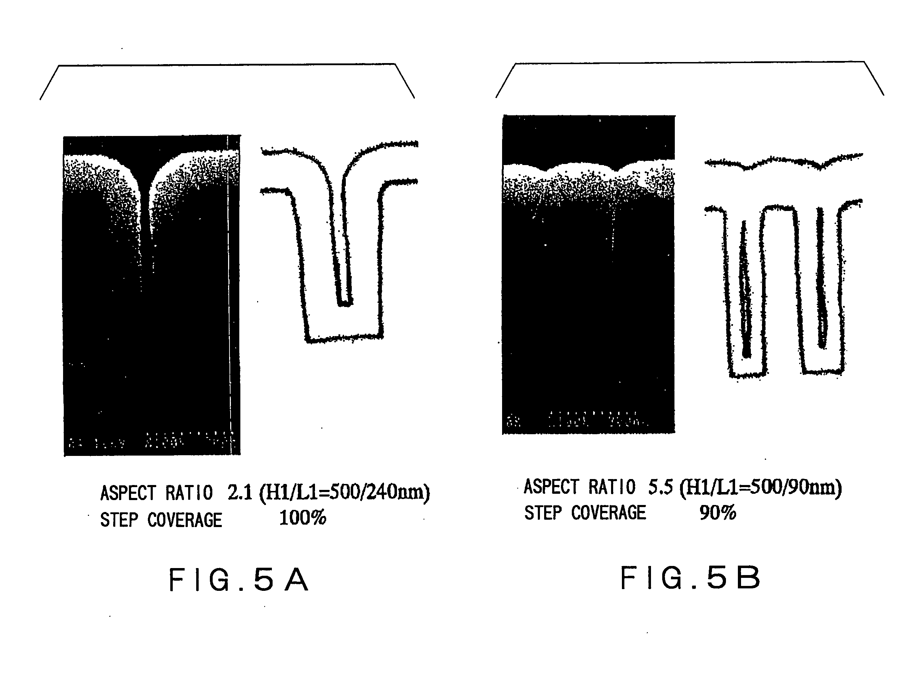

Fig. 4 shows an electron microscope photograph of a thin film deposited by the conventional, common CVD method (CVD conducted by supplying gases at the same time), and Figs. 5A and 5B show electron microscope photographs of thin films deposited by the method of the present invention. Each photograph is shown together with its sketch in order to facilitate the understanding of it.

The process conditions under which the film shown in Fig. 4 was deposited by the CVD method are as follows: Ta(Nt-Am)(NMe₂)₃ was used as a Ta source, which was supplied after being bubbled through Ar gas, a carrier gas. The supply flow rate of the Ta source was 2 sccm, and the flow rate of the carrier gas, 10 sccm. Further, the NH₃ gas flow rate was 20 sccm. The film deposition period was 40 minutes, the process pressure, 4.3 Pa, and the wafer temperature, 460°C.

Under the above-described process conditions, TaN film was deposited, as shown in Fig. 4, on a wafer surface having trenches with an aspect ratio of 1.8. The step coverage of this film was approximately 20% and was not high (good).

On the other hand, film deposition was conducted by the method of the present invention under the process conditions previously described with reference to Fig. 2, thereby depositing films as shown in Figs. 5A and 5B. Namely, the Ta source bubbled through Ar gas (carrier gas) and NH₃ gas were alternately supplied, and SiH₄ gas was also supplied simultaneously with the supply of the NH₃ gas. The Ta source feed flow rate was 10 sccm, and the carrier gas flow rate 100 sccm. Ar gas was used as a dilution gas, and its flow rate was 250 sccm. The process pressure and the heater preset temperature were 40 Pa (0.3 Torr) and 400°C (wafer temperature: ca. 350°C), respectively. Forty cycles of film deposition were repeated, and TaSiN film with a thickness of 95 nm was obtained. This is equivalent to a film deposition rate of 2.4 nm/cycle. Thus, there was attained a film deposition rate higher than that in the conventional ALD method.

The composition of the thin film deposited by the method of film deposition of the invention under the above-described conditions was as follows: Ta = 26 atomic%, Si = 11.1 atomic%, N = 54.1 atomic%, O = 3.5 atomic%, and C = 5.3 atomic%. The Si/Ta ratio and the N/Ta ratio were therefore 0.427 and 2.081, respectively. Thus, if Si is incorporated into a thin film, the film gets improved in oxidation resistance, so that when such a thin film is used as the lower electrode of an MIM (Metal Insulation Metal) capacitor device, separation of the lower electrode due to oxidation does not occur when a capacitor insulation film is formed.

The aspect ratio of the trench in the wafer shown in Fig. 5A is 2.1, and the step coverage of the film deposited on this trench was nearly 100%. On the other hand, the aspect ratio of the trench in the wafer shown in Fig. 5B is 5.5, and the step coverage of the film deposited on this trench was found to be about 90%. Thus, the method of film deposition of the present invention can make both step coverage and film deposition rate high.

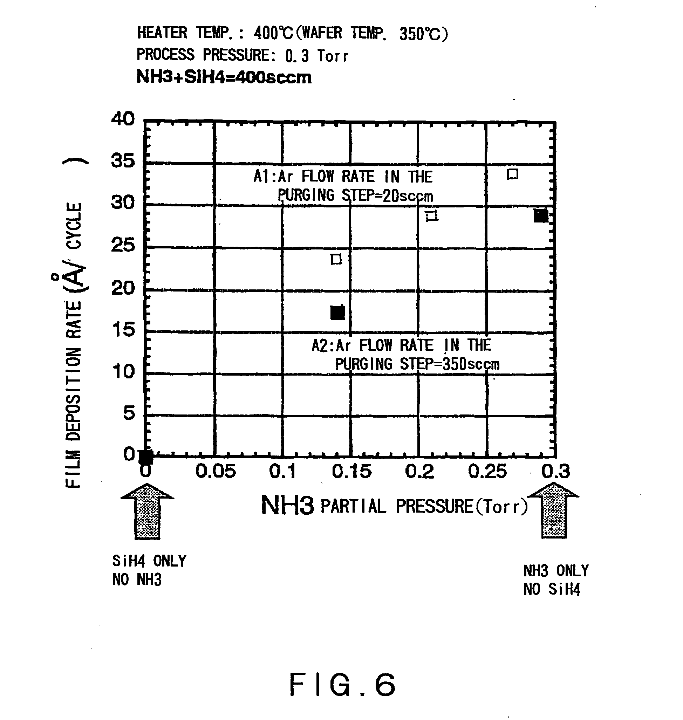

Next, the functions of NH₃ gas in the gas supply mode shown in Fig. 2 were evaluated. The results of the evaluation will be explained below. Fig. 6 is a graph showing the relationship between NH₃ gas partial pressure and film deposition rate, in the step of supplying NH₃ gas and SiH₄ gas, obtained by varying the NH₃ gas flow rate and the SiH₄ gas flow rate with the total of the two flow rates held at 400 sccm.

In this evaluation, the total of the respective process pressures is held at 0.3 Torr (40 Pa). The total pressure is preferably in the range of 0.1 to 5 Torr. In the graph, group A1 (white squares) shows the results obtained by feeding Ar gas at a flow rate of 20 sccm in the purging step, and group A2 (black squares), the results obtained by feeding Ar gas at a flow rate of 350 sccm in the purging step. As for the process temperature, the heater preset temperature was 400°C (wafer temperature = ca. 350°C). The wafer temperature is preferably more than 250°C and 750°C or less, more preferably more than 250°C and 550°C or less. The other process conditions were the same as those described above with reference to Fig. 2.

As is clear from the graph shown in Fig. 6, when only SiH₄ gas is supplied without supplying NH₃ gas, no film is deposited. On the other hand, when only Ta(Nt-Am)(NMe₂)₃ is continuously supplied at the same temperature and pressure, TaN film is deposited. This teaches the following: the Ta source is purged before it thermally decomposes to form a film because the period of the Ta-source-supplying step is short; or the deposited film adsorbs the SiH₄ gas supplied, and the adsorbed SiH₄ impedes the deposited film in absorption of the Ta source to hinder the growth of TaSiN film. If the flow rate of SiH₄ gas is zero, TaN film is deposited.

Moreover, it was confirmed that it is possible to increase gradually the film deposition rate by increasing the NH₃ partial pressure. The reason for this is considered that NH₃ gas accelerates the decomposition of the Ta source. In the above description, we have touched on the catalytic behavior of NH₃ by showing the fact that Ta(Nt-Am)(NMe₂)₃ decomposes in the presence of NH₃, whereby the temperature at which the compound can be deposited to form a film lowers by about 160°C. The fact that NH₃ accelerates the decomposition of Ta(Nt-Am)(NMe₂)₃ also explains the relationship between NH₃ partial pressure and film deposition rate.

Further, as the Ar gas flow rate in the purging step decreases, the film deposition rate increases. It is considered that although the purging step is needed to remove the gas remaining in the vessel, the film deposition rate lowers if the Ta source, which the wafer surface with trenches and holes has adsorbed, is excessively exhausted. It is therefore possible to increase deposition amount by increasing the NH₃ partial pressure and decreasing the SiH₄ partial pressure, or by decreasing the Ar gas flow rate in the purging step. In other words, by regulating the NH₃ partial pressure and the SiH₄ partial pressure, as well as the Ar gas flow rate in the purging step, the film deposition rate and the step coverage can be optimized. The SiH₄ partial pressure in the step of supplying NH₃ gas and SiH₄ gas is preferably 0.2 Torr or less, or 70% or less of the total pressure, more preferably 0.15 Torr or less, or 50% or less of the total pressure. The NH₃ partial pressure is preferably 0.075 Torr or more, or 20% or more of the total pressure. The Ar gas flow rate in the purging step is preferably in the range of 0 to 2000 sccm, more preferably of 0 to 100 sccm.

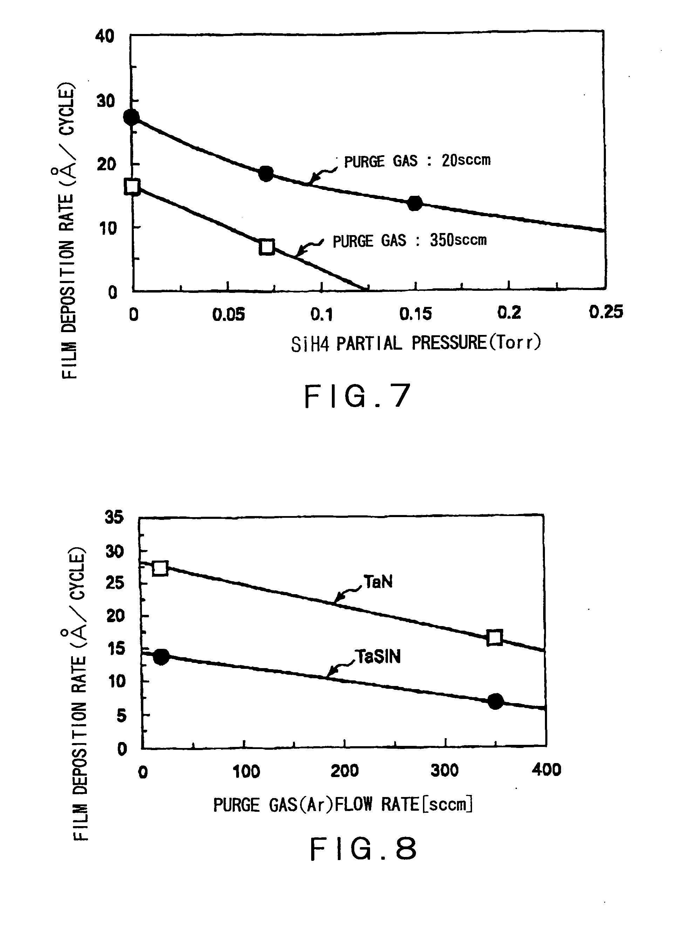

Examinations were carried out in order to evaluate the influence of SiH₄ partial pressure and Ar gas purge flow rate on film deposition rate. The results of the examinations will be explained below. Fig. 7 is a graph showing the relationship between SiH₄ partial pressure and film deposition rate, obtained by feeding the purge gas (Ar) at a flow rate of 20 sccm or 350 sccm. Fig. 8 is a graph showing the relationship between purge gas (Ar) flow rate and film deposition rate, obtained in the deposition of TaSiN or TaN film.

As is clear from the graph shown in Fig. 7, when the purge gas flow rate is 20 sccm, the film deposition rate decreases from 27 to about 10 angstroms per cycle, as the SiH₄ partial pressure increases from 0 to 0.25 Torr. On the other hand, when the purge gas flow rate is 350 sccm, the film deposition rate decreases from about 17 to 0 angstroms per cycle, as the SiH₄ partial pressure increases from 0 to 0.125 Torr. It was thus confirmed that the film deposition rate decreases almost linearly as the SiH₄ partial pressure increases, independently of the purge gas flow rate.

Further, as is clear from the graph shown in Fig. 8, the film deposition rate in the deposition of TaN decreases from 28 to 17.5 angstroms per cycle, as the purge gas flow rate increases from 0 to 400 sccm. On the other hand, the film deposition rate in the deposition of TaSiN decreases from 14 to 7.5 angstroms per cycle, as the purge gas flow rate increases from 0 to 400 sccm. It was thus confirmed that the film deposition rate increases almost linearly as the purge flow rate of Ar gas decreases, independently of the type of the film to be deposited.

Next, examinations were carried out in order to evaluate the dependence of film deposition rate on process temperature. The results of the examinations will be explained below.

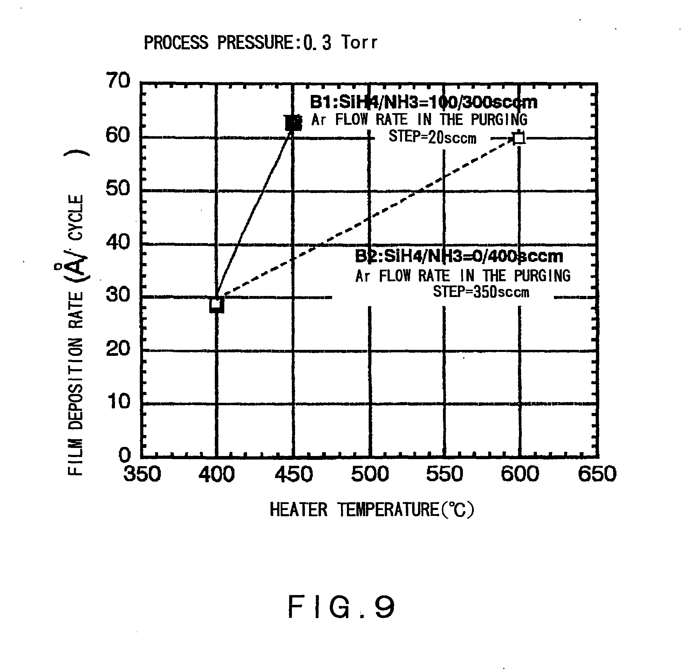

Fig. 9 is a graph showing the relationship between heater preset temperature and film deposition rate. In the graph, characteristic line B1 shows this relationship in the case where the SiH₄ flow rate and the NH₃ flow rate are 100 sccm and 300 sccm, respectively. On the other hand, characteristic line B2 shows the relationship in the case where the SiH₄ flow rate and the NH₃ flow rate are 0 sccm and 400 sccm, respectively. The other process conditions are the same as those mentioned previously with reference to Fig. 2.

These characteristic lines B1 and B2 show that the film deposition rate increases as the heater preset temperature (process temperature), i.e., the wafer temperature, is made higher. It was thus confirmed that it is possible to increase the film deposition rate by setting the heater to a higher temperature. As mentioned previously, the wafer temperature is lower than the heater preset temperature by about 20 to 60°C.

By using the Ta source alone or a gas mixture of the Ta source and NH₃, examinations were carried out in order to evaluate the dependence of film deposition rate on temperature in a low temperature range. The results of the examinations will be given below. Table 1 shows the results of the examinations.

**[Table 1]**

| Substrate Temperature | Source | | |
|---|---|---|---|
| (degC) | Ta (Nt-Am)(NMe₂)₃ | Ta(Nt-Am)(NMe₂)₃+NH₃ | W(CO)₆ |
| 350 | | | ○ |
| 300 | ○ | | ○ |
| 250 | × | | ○ |
| 200 | | | × |
| 180 | | ○ | |
| 150 | | | × |
| 140 | | ○ | |
| 120 | | × | |

| | | | |
|---|---|---|---|
| ○: film deposition was observed ×: no film deposition was observed | | | |

The substrate temperature (wafer temperature) was set within a low temperature range lower than the above-described temperature range and was varied in the range between 120°C and 350°C. The evaluation was carried out by using the following three types of material gas sources: Ta(Nt-Am)(NMe₂)₃ (Ta source) alone, a gas mixture of Ta(Nt-Am)(NMe₂)₃ and NH₃, and W(CO)₆ (W source) alone for comparison. W(CO)₆ is a high-melting-point organometallic material to be used to form tungsten film. In Table 1, the symbol "O" means that film deposition was observed, and the symbol "x" means that no film deposition was observed.

As is clear from Table 1, when the Ta source was used alone, film deposition was observed at 300°C but not observed at 250°C, while when the W source was used alone, film deposition was not observed at 200°C but observed at 250°C.

On the other hand, when a gas mixture of the Ta source and NH₃ was used, film deposition was observed at 140°C. It was thus confirmed that even at an extremely low temperature, it is possible to deposit a film. The reason for this is assumed that NH₃ acts catalytically, as mentioned previously, to accelerate the decomposition of the Ta source even at low temperatures. Further, as described above, when the Ta source was used alone, film deposition was not observed at a substrate temperature of 250°C or less but observed at a substrate temperature of 300°C, so that the decomposition-starting temperature of the Ta source was confirmed to be slightly higher than 250°C.

Therefore, by alternately supplying the Ta source and NH₃ gas, as in the method of the present invention, at a temperature equal to or higher than the above-described decomposition-starting temperature of slightly higher than 250°C, both CVD-type and ALD-type deposition can be realized. Consequently, the advantages of the two film deposition methods can be obtained; i.e., while retaining high film deposition rate, the step coverage can also be made high. With regard to the W (tungsten) source, the decomposition-starting temperature of the W (tungsten) source is slightly higher than 200°C. By depositing a W compound film at a temperature equal to or higher than this decomposition-starting temperature, both the step coverage and the film deposition rate can be made high.

### <Second Embodiment>

Next, the second embodiment of the present invention will be described.

In the first embodiment, the monosilane-supplying step (period T5: Fig. 2(D)) and the NH₃-supplying step (period T2: Fig. 2(B)) are simultaneously carried out for the same length of time. However, the present invention is not limited to this. Period T5 may be varied in order to regulate the silicon content of tantalum nitride film containing silicon (TaSiN).

In this embodiment, the process pressure is preferably in the range of 0.1 to 5 Torr. The wafer temperature is preferably more than 250°C and 750°C or less, more preferably more than 250°C and 550°C or less. The SiH₄ partial pressure in the step of supplying NH₃ gas and SiH₄ gas is preferably 0.2 Torr or less, or 70% or less of the total pressure, more preferably 0.15 Torr or less, or 50% or less of the total pressure. The NH₃ partial pressure is preferably 0.075 Torr or more, or 20% or more of the total pressure. Further, the purge flow rate of Ar gas in the purging step is from 0 to 2000 sccm, more preferably from 0 to 100 sccm.

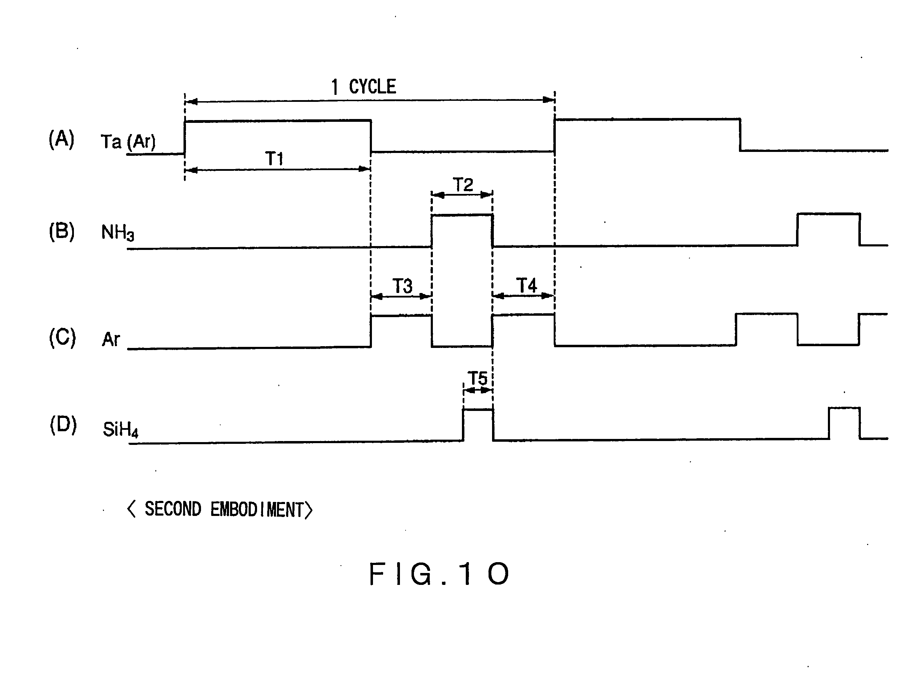

Fig. 10 shows a gas supply mode in the second embodiment of the present invention. Period T5 of the monosilane-supplying step is herein decreased to about half the period T5 in the first embodiment, as shown in Fig. 10(D). The supply modes of the other gases are the same as those in the first embodiment shown in Fig. 2.

Period T5 may be set to a suitable length of time. Further, the monosilane-supplying step, period T5, may be placed immediately after or before the NH₃-supplying step. In these cases, the length of time for one cycle becomes longer and the throughput slightly decreases.

The Ta source is a high-melting-point organometallic material, so that it of course contains C (carbon) and can form TaSiCN film.

### <Third Embodiment>

The third embodiment of the present invention will be described below.

The first embodiment has been described by referring to the case where silicon-containing tantalum nitride film (TaSiN) is formed as a metallic nitride film, a metallic compound film. The present invention is not limited to this, and silicon-carbon-containing tantalum nitride film (TaSiCN) may also be formed as a metallic nitride film.

In this embodiment, the process pressure is preferably in the range of 0.1 to 5 Torr. The wafer temperature is preferably more than 250°C and 750°C or less, more preferably more than 250°C and 550°C or less. The SiH₄ partial pressure in the step of supplying NH₃ gas and SiH₄ gas is preferably 0.2 Torr or less, or 70% or less of the total pressure, more preferably 0.15 Torr or less, or 50% or less of the total pressure. The NH₃ partial pressure is preferably 0.075 Torr or more, or 20% or more of the total pressure. The purge flow rate of Ar gas in the purging step is in the range of 0 to 2000 sccm, more preferably 0 to 100 sccm.

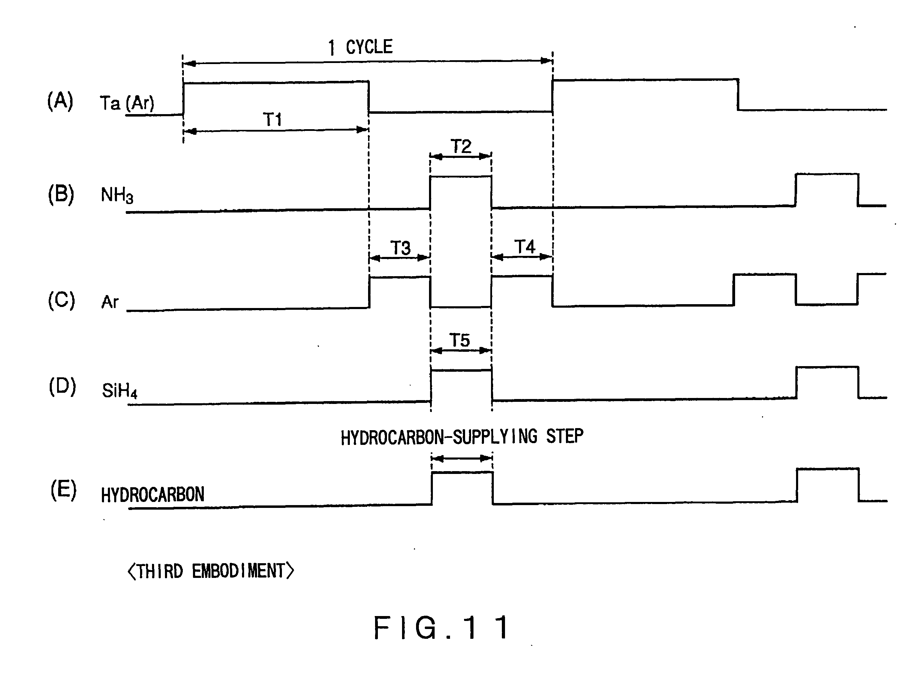

Fig. 11 shows a gas supply mode in the third embodiment of the present invention. As shown in Fig. 11(E), a hydrocarbon-gas-supplying step of supplying a hydrocarbon gas, as a carbon-containing gas, is carried out simultaneously with the above-described NH₃-supplying step and SiH₄-supplying step, which are carried out in synchronization with each other. By so carrying out the steps, carbon is doped in the metallic nitride film. It is a matter of course that a carbon-containing-gas-supplying system is provided as a reactant-gas-supplying system. Since the doped carbon can lower work function and specific resistance, the metallic nitride film (carbon-containing metallic nitride film) can have improved film quality.

Like the silane-supplying step shown in Fig. 10(D), the period of the hydrocarbon-gas-supplying step may be varied.

A hydrocarbon compound or a carbon-containing gas having one or more carbon atoms, such as acetylene, ethylene, methane, ethane, propane, or butane, can be used as the hydrocarbon gas (carbon-containing gas). TaSiC film is deposited when the NH₃ flow rate is made zero, and the Ta source, SiH₄ gas, and the hydrocarbon gas are used. If an organometallic W source is used instead of the Ta source, WSiC film can be deposited, and if an organometallic Ti source is used instead of the Ta source, TiSiC film can be deposited. When the SiH₄ flow rate is made zero, TaC film, WC film, and TiC film can be deposited in the respective cases. Furthermore, if both the NH₃ flow rate and the hydrocarbon gas flow rate are made zero without making the SiH₄ flow rate zero, TaSi film, WSi film, and TiSi film can be deposited in the respective cases. Instead of the Ta source, a Hf or Zr source may also be used.

In the above-described cases, it is a matter of course that an organic-Ti, W, Hf, or Zr-source-supplying system is provided as an organometallic-source-supplying system, as needed.

### <Fourth Embodiment>

The fourth embodiment of the present invention will be described below.

The first embodiment has been described by referring to the case where silicon-containing tantalum nitride film (TaSiN) is formed as a metallic nitride film. The present invention is not limited to this, and tantalum nitride film (TaN) containing no doped element may also be deposited as a metallic nitride film.

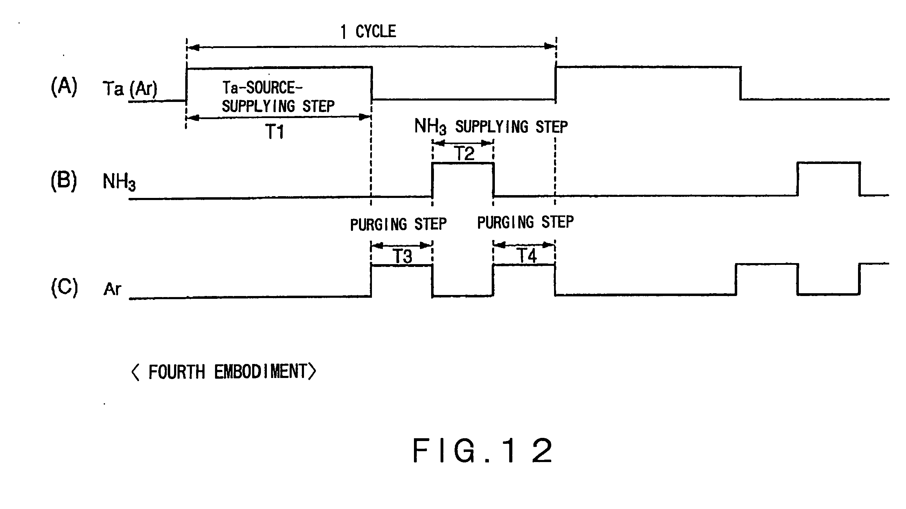

Fig. 12 shows a gas supply mode in the fourth embodiment of the present invention. This mode is equivalent to the gas supply mode shown in Fig. 2, from which the SiH₄-gas-supplying step shown in Fig. 2(D) is eliminated. In this mode, by supplying a hydrocarbon gas in synchronization with the supply of NH₃, TaCN film can be deposited. In this case, if the Ta source and the hydrocarbon gas are fed without feeding NH₃, TaC film can be deposited.

Under the following conditions, TaN film was deposited by the method of film deposition according to the present invention: the process pressure was 0.3 Torr (40 Pa); the heater preset temperature was 400°C (wafer temperature: about 350°C); and Ta(Nt-Am)(NMe₂)₃ was supplied as a Ta source after subjecting it to bubbling at a bottle temperature of 46.5°C. In the Ta-source-supplying step, Ar carrier gas and Ar dilution gas were fed at flow rates of 100 sccm and 250 sccm, respectively, for 30 seconds. In the purging step, Ar gas was fed at a flow rate of 20 sccm for 10 seconds. In the NH₃-gas-supplying step, NH₃ gas was fed at a flow rate of 200 sccm for 30 seconds. The composition of the TaN thin film deposited was as follows: Ta = 36.1 atomic%, Si = 0 atomic%, N = 49.4 atomic%, O = 6.3 atomic%, and C = 8.2 atomic%. The Si/Ta ratio and the N/Ta ratio were therefore 0 and 1.368, respectively.

### <Fifth Embodiment>

The fifth embodiment of the present invention will be described below.

In the above-described embodiments, the purging step is always carried out between the Ta-source-supplying step and the NH₃-supplying step. The present invention, however, is not limited to this. Some of the purging steps, e.g., the one immediately before or after the NH₃-supplying step, may be omitted. Alternatively, the processing vessel may be evacuated with all the purging steps omitted.

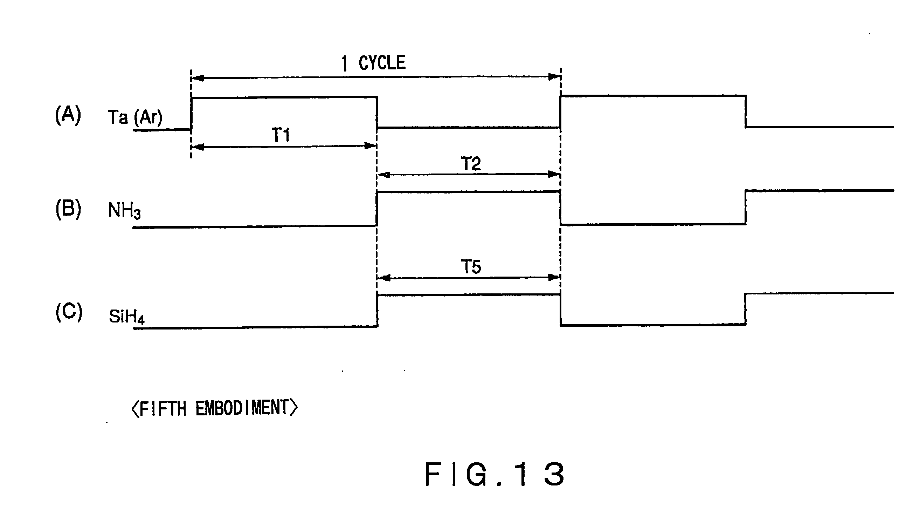

Fig. 13 shows a gas supply mode in the fifth embodiment of the present invention. As is clear from a comparison with Fig. 2, this gas supply mode is equivalent to the gas supply mode shown in Fig. 2, from which all the purging steps using Ar gas are omitted. In this mode, therefore, only the Ta source, NH₃ gas, and SiH₄ gas are supplied in the respective gas-supplying steps. This embodiment slightly decreases step coverage, but can further improve film deposition rate.

Although the above embodiments have been described by referring to the case where monosilane is used as the silicon-containing gas, the present invention is not limited to this. A gas selected from the group consisting of monosilane [SiH₄], disilane [Si₂H₆], methylsilane [CH₃SiH₃], dimethylsilane [(CH₃)₂SiH₂], hexamethyldisilazane (HMDS), disilylamine (DSA), trisilylamine (TSA), bistertiarybutylaminosilane (BTBAS), trimethylsilane, tetramethylsilane, bisdimethylaminosilane, tetradimethylaminosilane, triethylsilane, and tetraethylsilane can be used as the silicon-containing gas.

Further, although the above embodiments have been described by referring to the case where ammonia is used as the nitrogen-containing gas, the present invention is not limited to this. A compound selected from the group consisting of ammonia [NH₃], hydrazine [NH₂NH₂], methylhydrazine [(CH₃)(H)NNH₂], dimethylhydrazine [(CH₃)₂NNH₂], t-butylhydrazine [(CH₃)₃C(H)NNH₂], phenylhydrazine [C₆H₅N₂H₃], 2,2'-azo-isobutane [(CH₃)₆C₂N₂], ethylazide [C₂H₅N₃], pyridine [C₅H₅N], and pyrimidine [C₄H₄N₂] can be used as the nitrogen-containing gas.

Furthermore, a gas of a compound selected from the group consisting of acetylene, ethylene, methane, ethane, propane and butane can be used as the carbon-containing gas.

Although the above-described embodiments have been described by referring to the case where Ta(Nt-Am)(NMe₂)₃ is used as a high-melting-point organometallic material containing tantalum, the present invention is not limited to this. A compound selected from the group consisting of t-butyliminotris(diethylamino)tantalum
(TBTDET):[(NEt₂)₃TaN-Bu^{t}],
pentakis(ethylmethylamino)tantalum (PEMAT): [Ta(NMeEt)₅],
pentakis(dimethylamino)tantalum (PDMAT):[Ta(NMe₂)₅],
pentakis(diethylamino)tantalum (PDEAT): [Ta(NEt₂)₆],
t-butyliminotris(ethylmethylamino)tantalum
(TBTMET):[(NEt₂Me)₃TaN-Bu^{t}],
t-amylimidotris(dimethylamino)tantalum
(TBTDMT):[(NMe₂)₃TaN-Bu^{t}], and
t-amylimidotris(dimethylamino)tantalum
(Taimata):[(NMe₂)₃TaNC(CH₃)₂CH₅](Ta(Nt-Am)(NMe₂)₃) can be used as a high-melting-point organometallic material containing tantalum.

A compound selected from the group consisting of tetrakisdiethylaminotitanium Ti[N(C₂H₅)₂]₄, tetrakisdimethylaminotitanium Ti[N(CH₃)₂]₄, and tetrakisethylmethylaminotitanium Ti[N(CH₃)(C₂H₅)]₄ can be used as a high-melting-point organometallic material containing titanium.

A compound selected from the group consisting of hexacarbonyltungsten W(CO)₆, and bistertiarybutylimidobisdimethyl-amidotungsten (t-Bu^{t}N)₂(Me₂N)₂W can be used as a high-melting-point organometallic material containing tungsten.

A compound selected from the group consisting of tetrakisdimethylaminohafnium Hf[N(CH₃)₂]₄, and dimethylbis(cyclopenta-dienyl)hafnium Hf(CH₃)₂(C₅H₅)₂ can be used as a high-melting-point organometallic material containing hafnium.

Furthermore, although the above-described embodiments have been described by referring mainly to the case where tantalum is used as a high-melting-point metal in the high-melting-point organometallic material, the present invention is not limited to this. As mentioned previously, the high-melting-point metal is not limited to tantalum only and it may also be Ti (titanium), W (tungsten), Hf (hafnium), or Zr (zirconium). By allowing a reactant gas such as a nitrogen-, silicon-, or carbon-containing gas to react with the high-melting-point organometallic material gas in the above-described manner, there can be deposited films of various metallic compounds.

Although a single wafer processing system, in which wafers are processed sheet by sheet, has been described above, the present invention is not limited to this. The present invention is also applicable to a film deposition system using a batch-type upright processing vessel, capable of processing two or more wafers at the same time.

Furthermore, although the above embodiments have been described by referring to the case where the object to be processed is a semiconductor wafer, the present invention is not limited to this and is, of course, applicable to LCD substrates, glass substrates, ceramic substrates, etc.

## Claims

1. A method of film deposition that comprises:
a first gas-supplying step of supplying a high-melting-point organometallic material gas to a processing vessel that can be evacuated, and
a second gas-supplying step of supplying, to the processing vessel, a gas consisting of one, or two or more gases selected from a nitrogen-containing gas, a silicon-containing gas and a carbon-containing gas,
wherein a thin metallic compound film composed of one, or two or more compounds selected from a high-melting-point metallic nitride, a high-melting-point metallic silicate, and a high-melting-point metallic carbide is deposited on the surface of an object to be processed, placed in the processing vessel,
**characterized in that** the first and second gas-supplying steps are alternately carried out, and
that, in the first and second gas-supplying steps, a temperature of the object to be processed is kept equal to or higher than a decomposition-starting temperature of the high-melting-point organometallic material.

2. The method of film deposition according to claim 1, wherein a purging step of purging the gas remaining in the processing vessel is carried out between the first and second gas-supplying steps.

3. The method of film deposition according to claim 1, wherein a purging step of purging the gas remaining in the processing vessel is carried out after the first gas-supplying step and before the second gas-supplying step so that at least the high-melting-point organometallic material gas remains in the atmosphere in the processing vessel.

4. The method of film deposition according to any of claims 1 to 3, wherein the second gas-supplying step comprises a step of supplying a nitrogen-containing gas, and a metallic-nitride-containing compound film is deposited.

5. The method of film deposition according to any of claims 1 to 4, wherein the second gas-supplying step comprises a step of supplying a silicon-containing gas, and a silicon-containing metallic compound film is deposited.

6. The method of film deposition according to claim 5, wherein the silicon-containing gas is selected from the group consisting of monosilane [SiH₄], disilane [Si₂H₆], methylsilane [CH₃SiH₃], dimethylsilane [(CH₃)₂SiH₂], hexamethyldisilazane (HMDS), disilylamine (DSA), trisilylamine (TSA), bistertiarybutylaminosilane (BTBAS), trimethylsilane, tetramethylsilane, bisdimethylaminosilane, tetradimethylaminosilane, triethylsilane, and tetraethylsilane.

7. The method of film deposition according to any of claims 4 to 6, wherein the second gas-supplying step comprises a step of supplying a nitrogen-containing gas and a step of supplying a silicon-containing gas, the step of supplying a silicon-containing gas being carried out in the step of supplying a nitrogen-containing gas, and a metallic-nitride-containing compound film and a silicon-containing metallic compound film are deposited.

8. The method of film deposition according to any of claims 1 to 7, wherein the second gas-supplying step comprises a step of supplying a carbon-containing gas, and a metallic-carbide-containing compound film is deposited.

9. The method of film deposition according to claim 8, wherein the second gas-supplying step comprises a step of supplying a nitrogen-containing gas and a step of supplying a carbon-containing gas, the step of supplying a carbon-containing gas being carried out in the step of supplying a nitrogen-containing gas, and a metallic-nitride-containing compound film and a metallic-carbide-containing compound film are deposited.

10. The method of film deposition according to any of claims 1 to 9, wherein the high-melting-point organometallic material contains a metal selected from Ta (tantalum), Ti (titanium), W (tungsten), Hf (hafnium), and Zr (zirconium).

11. The method of film deposition according to claim 10, wherein the high-melting-point organometallic material is a high-melting-point organometallic material containing tantalum and is a compound selected from the group consisting of t-butyliminotris(diethylamino)tantalum
(TBTDET): [(NEt₂)₃TaN-Bu^{t}],
pentakis(ethylmethylamino)tantalum (PEMAT):[Ta(NMeEt)₅],
pentakis(dimethylamino)tantalum (PDMAT): [Ta(NMe₂)₅],
pentakis(diethylamino)tantalum (PDEAT):[Ta(NEt₂)₆],
t-butyliminotris(ethylmethylamino)tantalum
(TBTMET):[(NEt₂Me)₃TaN-Bu^{t}],
t-amylimidotris(dimethylamino)tantalum
(TBTDMT):[(NMe₂)₃TaN-Bu^{t}], and
t-amylimidotris(dimethylamino)tantalum
(Taimata):[(NMe₂)₃TaNC(CH₃)₂-C₂H₅](Ta(Nt-Am)(NMe₂)₃).

12. The method of film deposition according to claim 10, wherein the high-melting-point organometallic material is a high-melting-point organometallic material containing titanium and is a compound selected from the group consisting of tetrakisdiethylaminotitanium Ti[N(C₂H₅)₂]₄, tetrakisdimethylaminotitanium Ti[N(CH₃)₂]₄, and tetrakisethylmethyl-aminotitanium Ti[N(CH₃)(C₂H₅)]₄.

13. The method of film deposition according to claim 10, wherein the high-melting-point organometallic material is a high-melting-point organometallic material containing tungsten and is a compound selected from the group consisting of hexacarbonyltungsten W(CO)₆, and bistertiarybutylimidobisdimethylamidotungsten (t-Bu^{t}N)₂(Me₂N)₂W.

14. The method of film deposition according to claim 10, wherein the high-melting-point organometallic material is a high-melting-point organometallic material containing hafnium and is a compound selected from the group consisting of tetrakisdimethylaminohafnium Hf[N(CH₃)₂]₄, and dimethylbis(cyclopentadienyl)hafnium Hf(CH₃)₂ (C₅H₅)₂.

15. The method of film deposition according to any of claims 1 to 14, wherein the nitrogen-containing gas is a compound selected from the group consisting of ammonia [NH₃], hydrazine [NH₂NH₂], methylhydrazine [(CH₃)(H)NNH₂], dimethylhydrazine [(CH₃)₂NNH₂], t-butylhydrazine [(CH₃)₃C(H)NNH₂], phenylhydrazine [C₆H₅N₂H₃], 2,2'-azoisobutane [(CH₃)₆C₂N₂], ethylazide [C₂H₅N₃], pyridine [C₅H₅N], and pyrimidine [C₄H₄N₂].

16. The method of film deposition according to any of claims 1 to 15, wherein the carbon-containing gas is a compound selected from the group consisting of acetylene, ethylene, methane, ethane, propane, and butane.

17. A film deposition system comprising:
a processing vessel that can be evacuated,
a supporting unit for supporting, in the processing vessel, an object to be processed,
a heating unit for heating the object to be processed supported by the supporting unit,
a high-melting-point-organometallic-material-gas-supplying unit for supplying a high-melting-point organometallic material gas,
a reactant-gas-supplying system for supplying a gas, or two or more gases, selected from a nitrogen-containing gas, a silicon-containing gas, and a carbon-containing gas,
a gas-feeding unit connected to the high-melting-point-organometallic-material-gas-supplying unit and the reactant-gas-supplying system, for feeding to the processing vessel the gas, or the two or more gases, selected from a nitrogen-containing gas, a silicon-containing gas and a carbon-containing gas, and the high-melting-point organometallic material gas, and
a controller for controlling the gas-feeding unit and the heating unit, in order to deposit a thin metallic compound film on the object to be processed, in such a manner that a step of supplying the high-melting-point organometallic material gas and a step of supplying the gas, or the two or more gases, selected from a nitrogen-containing gas, a silicon-containing gas, and a carbon-containing gas are alternately carried out and that a temperature of the object to be processed is kept equal to or higher than a decomposition-starting temperature of the high-melting-point organometallic material.

18. The film deposition system according to claim 17, further comprising a gas-exhausting unit for exhausting the gas in the processing vessel, wherein the controller is adapted to control the gas-feeding unit and the gas-exhausting unit in such a manner that a purging step of purging the gas remaining in the processing vessel is carried out after the step of supplying the high-melting-point organometallic material gas and before the step of supplying the gas, or the two or more gases, selected from a nitrogen-containing gas, a silicon-containing gas and a carbon-containing gas, so that at least the high-melting-point organometallic material gas remains in the atmosphere in the processing vessel.

19. A storage medium that stores a computer program with which a computer performs a method of controlling a film deposition system including:
a processing vessel that can be evacuated,
a supporting unit for supporting, in the processing vessel, an object to be processed,
a heating unit for heating the object to be processed, supported by the supporting unit,
a high-melting-point-organometallic-material-gas-supplying unit for supplying a high-melting-point organometallic material gas,
a reactant-gas-supplying system for supplying a gas, or two or more gases, selected from a nitrogen-containing gas, a silicon-containing gas, and a carbon-containing gas, and
a gas-feeding unit connected to the high-melting-point-organometallic-material-gas-supplying unit and the reactant-gas-supplying system, for feeding to the processing vessel the gas, or the two or more gases, selected from a nitrogen-containing gas, a silicon-containing gas and a carbon-containing gas, and the high-melting-point organometallic material gas,
the method being for controlling the gas-feeding unit and the heating unit, in order to deposit a thin metallic compound film on the object to be processed, in such a manner that a step of supplying the high-melting-point organometallic material gas and a step of supplying the gas, or the two or more gases, selected from a nitrogen-containing gas, a silicon-containing gas, and a carbon-containing gas are alternately carried out and that a temperature of the object to be processed is kept equal to or higher than a decomposition-starting temperature of the high-melting-point organometallic material.
